# FASCICULE DE BREVET EUROPEEN

(11) **EP 2 959 304 B1**
(45) Date de publication et mention de la délivrance du brevet: **25.12.2024**
(21) Numéro de dépôt: 14709209.2
(22) Date de dépôt: 21.02.2014
(51) Int. Cl.: G01R 31/12, H02H 1/00, H02S 50/10, H02H 7/20, G01R 31/40

(54) **PROCEDE ET DISPOSITIF DE DETECTION D'ARC ELECTRIQUE DANS UNE INSTALLATION PHOTOVOLTAÏQUE**
VERFAHREN UND VORRICHTUNG ZUR ERKENNUNG VON LICHTBÖGEN IN EINER FOTOVOLTAIKANLAGE
METHOD AND DEVICE FOR DETECTING AN ELECTRIC ARC IN A PHOTOVOLTAIC FACILITY

(30) Priorité: 22.02.2013 FR 1351556
(43) Date de publication de la demande: 30.12.2015
(73) Titulaire: Commissariat à l'Energie Atomique et aux Energies Alternatives, 75015 Paris (FR); Socomec, 67230 Benfeld (FR)
(72) Inventeur: LESPINATS, Sylvain, F-73100 Aix-les-Bains (FR); CHAINTREUIL, Nicolas, F-73800 Montmelian (FR); KERN, Christian, F-68240 Sigolsheim (FR); PLISSONNIER, Alexandre, F-38800 Pont-de-Claix (FR)
(74) Mandataire: Novaimo
(86) Numéro de dépôt international: PCT/EP2014/053438
(87) Numéro de publication internationale: WO 2014/128263

(56) Documents cités:
- EP-A2- 2 393 178
- WO-A1-2011/017721
- WO-A1-2013/083723
- SCHIMPF F ET AL: "Recognition of electric arcing in the DC-wiring of photovoltaic systems", TELECOMMUNICATIONS ENERGY CONFERENCE, 2009. INTELEC 2009. 31ST INTERNATIONAL, IEEE, PISCATAWAY, NJ, USA, 18 October 2009 (2009-10-18), pages 1 - 6, XP031579534, ISBN: 978-1-4244-2490-0
- XIU YAO ET AL: "The detection of DC arc fault: Experimental study and fault recognition", APPLIED POWER ELECTRONICS CONFERENCE AND EXPOSITION (APEC), 2012 TWENTY-SEVENTH ANNUAL IEEE, IEEE, 5 February 2012 (2012-02-05), pages 1720 - 1727, XP032127899, ISBN: 978-1-4577-1215-9, DOI: 10.1109/APEC.2012.6166054

## Description

L'invention concerne un procédé de détection d'un arc électrique dans un système photovoltaïque. Elle concerne aussi un dispositif de sécurité détectant l'apparition d'arcs électriques, et un module photovoltaïque et un système photovoltaïque équipés d'un tel dispositif de sécurité détectant l'apparition d'arcs électriques.

Les installations photovoltaïques fonctionnent à tension continue et courant continu importants, ce qui engendre des risques d'apparition d'arcs électriques. De tels arcs électriques peuvent survenir suite à une erreur de manipulation, par exemple si un opérateur ouvre malencontreusement un connecteur en charge, ou suite à la dégradation des connexions de l'installation. Ces arcs électriques génèrent une forte chaleur de plasma pendant une durée importante puisque sous tension continue, la valeur de la tension n'est jamais nulle au contraire d'un système alternatif, et sont de ce fait très dangereux pour les personnes et les installations. De plus, l'intégration des modules photovoltaïques dans la toiture des bâtiments risque de déclencher l'incendie des charpentes en cas d'arc électrique.

Les installations photovoltaïques peuvent être reliées au réseau électrique par l'intermédiaire d'un onduleur. Dans une telle configuration, il existe des systèmes de sécurité permettant de détecter un éventuel arc électrique survenant sur la liaison électrique entre un champ de modules photovoltaïques et l'onduleur. Toutefois, ces systèmes sont insuffisants puisqu'un tel arc électrique est susceptible de se produire au niveau d'un module photovoltaïque lui-même. Il n'existe aucune solution de sécurité contre un tel risque.

Le document WO2010072717 de l'état de la technique propose la détection d'un arc électrique dans une installation photovoltaïque sur la base de l'analyse d'une onde ultrasonore et la reconnaissance de la signature ultrasonore d'un arc électrique dans cette onde. Pour cela, cette solution analyse en continu les signatures ultrasonores. Il en résulte une méthode nécessitant un calcul complexe et un dispositif coûteux,

Le document WO2011017721 décrit la détection d'un arc électrique dans une installation photovoltaïque, à partir d'un calcul d'une moyenne de mesures de tensions et de courants.

Le document FR2912848 décrit une méthode simplifiée de détection d'un arc électrique à partir de la simple mesure de tension et de la détection de son augmentation rapide. Toutefois, cette méthode est insuffisante pour faire la distinction entre un arc électrique et différents événements distincts qui induisent aussi une augmentation de tension.

Ainsi, un objet général de l'invention est de proposer une solution de détection d'un arc électrique dans une installation photovoltaïque, simple, peu coûteuse et fiable, afin d'améliorer la sécurité de telles installations.

A cet effet, l'invention repose sur un procédé de détection d'un arc électrique dans une installation photovoltaïque, caractérisé en ce qu'il comprend les étapes suivantes :
- Mesure de valeurs de tension en au moins un endroit du circuit électrique de l'installation photovoltaïque ;
- Numérisation des valeurs de tension mesurées pour former des données de tension ;
- Formation d'une fenêtre de n données de tension numérisées récentes;
- Calcul d'une valeur de test associée à ladite fenêtre des n données de tension, cette valeur reposant sur la seule mesure de la tension;
- Analyse d'un vecteur de test comprenant m valeurs de test associées à m fenêtres récentes générant une grandeur issue de cette analyse représentative d'un risque d'arc électrique, cette grandeur reposant sur la seule mesure de la tension ;
- Comparaison de cette grandeur issue avec au moins un seuil pour en déduire la présence ou non d'un arc électrique au sein de l'installation photovoltaïque.

L'étape de formation d'une fenêtre de n données de tension numérisées peut consister à ajouter à la fenêtre précédemment formée une donnée nouvellement numérisée et à supprimer une donnée ancienne de la fenêtre.

L'étape de calcul d'une valeur de test associée à la fenêtre des n données comprend l'un des calculs suivants :
- calcul de la différence entre la donnée la plus récente et la donnée la plus ancienne de la fenêtre ou calcul de la différence entre la seconde donnée la plus récente et l'avant-dernière donnée la plus ancienne de la fenêtre, ou calcul de toute autre différence entre une donnée plus récente ou une moyenne de quelques données plus récentes de la fenêtre et une donnée plus ancienne ou la moyenne de quelques données plus anciennes de la fenêtre ; ou
- calcul du rapport entre une donnée plus récente ou une moyenne de données plus récentes de la fenêtre et une donnée plus ancienne ou une moyenne de données plus anciennes de la fenêtre.

L'étape de calcul d'une valeur de test associée à la fenêtre des n données peut comprendre la comparaison du résultat du calcul de différence ou du rapport entre une donnée plus récente ou une moyenne de données plus récentes de la fenêtre et une donnée plus ancienne ou une moyenne de données plus anciennes de la fenêtre avec un ou plusieurs seuils et l'affectation d'une valeur de test prédéfinie, comme -2, -1, 0, 1 ou 2, en fonction de cette comparaison.

L'étape d'analyse du vecteur de test peut comprendre la somme des valeurs de test ou un calcul de type statistique sur les valeurs de test du vecteur de test, comme la moyenne ou la médiane, pour obtenir comme résultat une grandeur représentative du risque de présence d'arc électrique.

Le procédé de détection d'un arc électrique dans une installation photovoltaïque peut comprendre une étape de comparaison de la grandeur avec un premier seuil pour en déduire la présence ou non d'un arc électrique de type série et la comparaison de cette grandeur avec un second seuil de signe opposé au premier seuil pour en déduire la présence ou non d'un arc électrique de type parallèle.

Le procédé de détection d'un arc électrique dans une installation photovoltaïque peut comprendre la répétition des étapes suivantes à chaque nouvelle mesure de tension :
- formation d'une nouvelle fenêtre par effacement de la donnée de tension la plus ancienne de la fenêtre précédente et l'ajout de la donnée de tension la plus récente ;
- calcul de la valeur de test de la nouvelle fenêtre ;
- élaboration d'un nouveau vecteur de test, dans lequel on supprime la valeur de test associée à la fenêtre la plus ancienne et on ajoute la nouvelle valeur de test puis
- détection ou non de la présence d'un arc électrique à partir de ce nouveau vecteur de test,
- si aucun arc électrique n'est détecté, itération des étapes précédentes à partir d'une nouvelle mesure de tension.

Le procédé de détection d'un arc électrique dans une installation photovoltaïque peut comprendre une étape de mémorisation des données de tension de la fenêtre et des valeurs de test du vecteur de test à chaque itération.

Le procédé de détection d'un arc électrique dans une installation photovoltaïque peut comprendre la réalisation des étapes de détection ou non de la présence d'un arc électrique en temps réel.

Le procédé de détection d'un arc électrique dans une installation photovoltaïque peut combiner les étapes de détection d'un arc électrique dans l'installation photovoltaïque à partir d'une même mesure de tension pour deux fenêtres comprenant un nombre différent de données.

Le procédé de détection d'un arc électrique dans une installation photovoltaïque peut comprendre une mesure de tension à une fréquence d'échantillonnage comprise entre 50 kHz et 10M Hz.

S'il est estimé qu'il existe un arc électrique au sein de l'installation photovoltaïque, le procédé peut comprendre une étape consistant à intervenir automatiquement sur le circuit électrique de l'installation photovoltaïque pour mettre l'installation photovoltaïque en sécurité.

L'invention porte aussi sur un dispositif de sécurité pour une installation photovoltaïque, comprenant un ou plusieurs capteur(s) de mesure de tension, relié(s) par une liaison de communication à une unité de traitement, comprenant un convertisseur analogique numérique pour numériser les mesures reçues par le ou les capteur(s) de mesure de tension, caractérisé en ce que l'unité de traitement est configurée pour mettre en oeuvre le procédé de détection d'un arc électrique dans l'installation photovoltaïque tel que décrit précédemment.

L'unité de traitement peut être reliée par un moyen de communication à un dispositif d'intervention dont la fonction est de mettre l'installation en sécurité en cas d'arc électrique.

Enfin, l'invention porte aussi sur une installation photovoltaïque, caractérisée en ce qu'elle comprend au moins un dispositif de sécurité tel que décrit ci-dessus.

Ces objets, caractéristiques et avantages de la présente invention seront exposés en détail dans la description suivante d'un mode d'exécution particulier fait à titre non-limitatif en relation avec les figures jointes parmi lesquelles :
La figure 1 illustre schématiquement une installation photovoltaïque.
La figure 2 représente un exemple d'évolution de la tension au sein d'une installation photovoltaïque en fonction du temps en présence d'un arc électrique.
La figure 3 illustre schématiquement un dispositif de sécurité associé à une installation photovoltaïque selon un mode d'exécution de l'invention.
La figure 4 illustre quelques étapes du procédé de détection d'arc électrique au sein d'une installation photovoltaïque selon un mode d'exécution de l'invention.
La figure 5 représente une signature électrique d'un arc série au sein d'une installation photovoltaïque.
La figure 6 représente une signature électrique d'un arc parallèle au sein d'une installation photovoltaïque.
La figure 7 représente une hausse de tension au sein d'une installation photovoltaïque.
La figure 8 représente la tension mesurée incluant une erreur d'acquisition au sein d'une installation photovoltaïque.
La figure 9 représente la tension mesurée au sein d'une installation photovoltaïque en présence d'une perturbation au niveau de son onduleur.

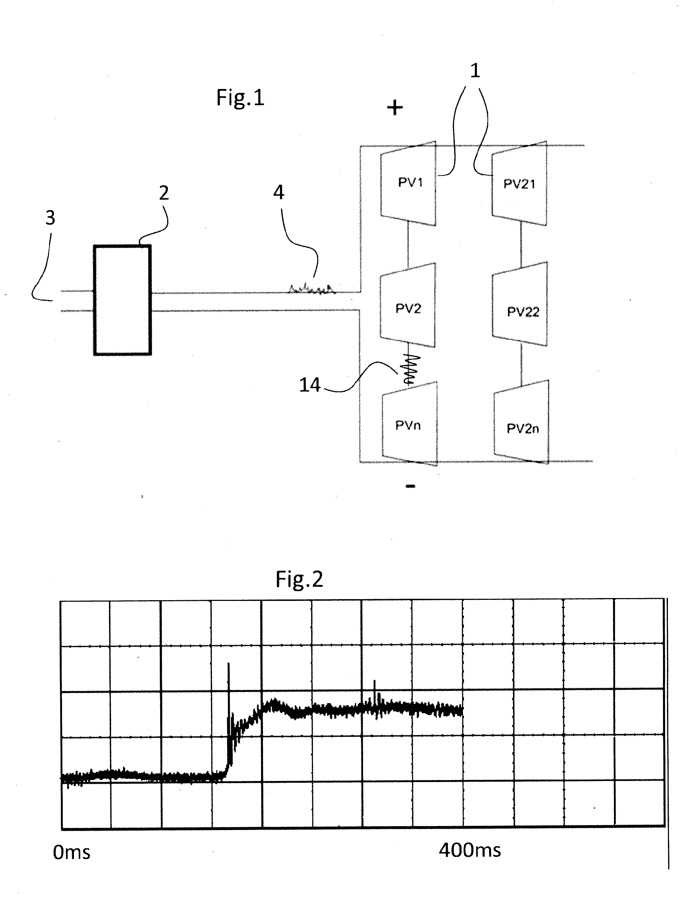

L'invention repose sur la seule mesure de la tension au sein d'une installation photovoltaïque. Cette dernière, représentée schématiquement sur la figure 1, comprend plusieurs modules photovoltaïques 1 (PVi) reliés à un onduleur 2 qui convertit le courant continu produit par les modules photovoltaïques 1 en un courant alternatif, pour une liaison sur un réseau électrique 3 standard, non représenté.

A partir d'une mesure de tension, l'invention cherche à déduire la présence ou non d'un arc électrique au sein d'une installation photovoltaïque. Un tel arc électrique peut se trouver au niveau d'un ou plusieurs module(s) photovoltaïque(s) 1, notamment sur une liaison comprenant plusieurs modules photovoltaïques disposés en série : on parle alors d'arc électrique « série » 14. Un tel arc électrique peut aussi se trouver entre ces modules photovoltaïques et un onduleur 2, ou à tout endroit sur une liaison parallèle à plusieurs modules : on parle alors d'arc électrique « parallèle » 4.

Un arc électrique provoque une variation importante de la tension au sein de l'installation photovoltaïque. Cette tension, mesurée sur une liaison électrique subissant un arc électrique série peut prendre une forme telle qu'illustrée en figure 2 selon un exemple. L'augmentation du signal de tension peut apparaître en même temps que l'arc, et durer de quelques millisecondes à quelques heures. Plus généralement, l'amplitude du signal obtenue dépend de la position du détecteur et d'autres paramètres. Cette variation de la tension induit une augmentation de la variabilité du signal.

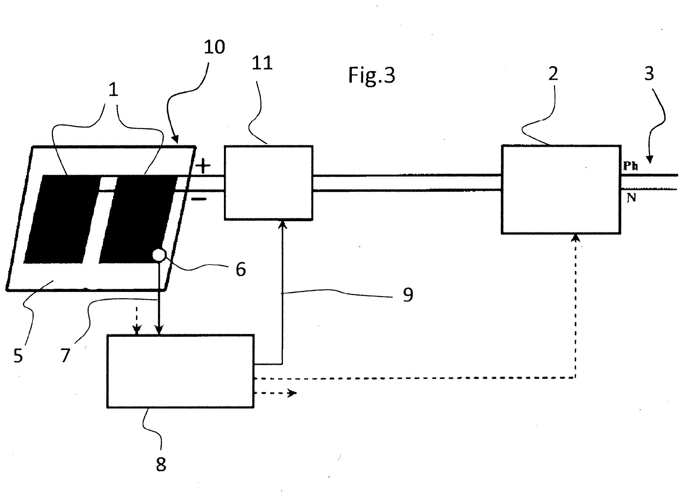

La figure 3 représente schématiquement un dispositif de sécurité pour une installation photovoltaïque 10 telle que décrite sur la figure 1, qui comprend deux modules photovoltaïques 1 à titre d'exemple simplifié montés sur un châssis 5, qui sont reliés au réseau électrique traditionnel 3 par l'intermédiaire d'un onduleur 2. Le dispositif de sécurité comprend un ou plusieurs capteur(s) de mesure de tension 6, positionné(s) par exemple au niveau d'un module photovoltaïque 1 et/ou à tout autre endroit du circuit électrique de l'installation photovoltaïque. Ce (ou ces) capteur de mesure de tension 6 est relié par une liaison de communication 7 à une unité de traitement 8 apte à analyser les données transmises par le(s) capteur(s) de mesure de tension 6. Cette unité de traitement 8 est elle-même reliée par un moyen de communication 9 à un dispositif d'intervention 11 dont la fonction est d'interrompre l'arc électrique sur demande de l'unité de traitement 8 en cas d'arc électrique, pour supprimer tout risque électrique et toute future détérioration.

L'unité de traitement 8 comprend un convertisseur analogique numérique, pour numériser les données reçues provenant du ou des capteur(s) de mesure de tension. Elle a pour fonction d'analyser les données reçues par le(s) capteur(s) de mesure de tension 6 et met en oeuvre un procédé de détection d'arcs électriques, qui sera détaillé ci-dessous. Pour cela, elle peut comprendre une unité de calcul, comme un microcontrôleur, et des moyens de mémorisation, ou plus généralement tout composant matériel (hardware) et/ou logiciel (software). En remarque, comme les données à traiter sont numérisées, il est possible d'utiliser un ou plusieurs microcontrôleurs déjà existant(s) au sein d'une installation photovoltaïque pour mettre en oeuvre le procédé de détection d'arc électrique qui sera détaillé ci-dessous, sans ajout d'un composant additionnel. La solution est donc peu coûteuse.

Enfin, le dispositif de sécurité 10 peut être soit disposé sur une des bornes à la sortie de l'installation photovoltaïque, soit se trouver sur chaque module photovoltaïque, par exemple dans sa boîte de raccordement. Toute solution intermédiaire est naturellement envisageable. Il permet une intervention adaptée au type d'arc électrique détecté, série ou parallèle, et de préférence de manière localisée, au plus proche de la localisation de l'arc électrique.

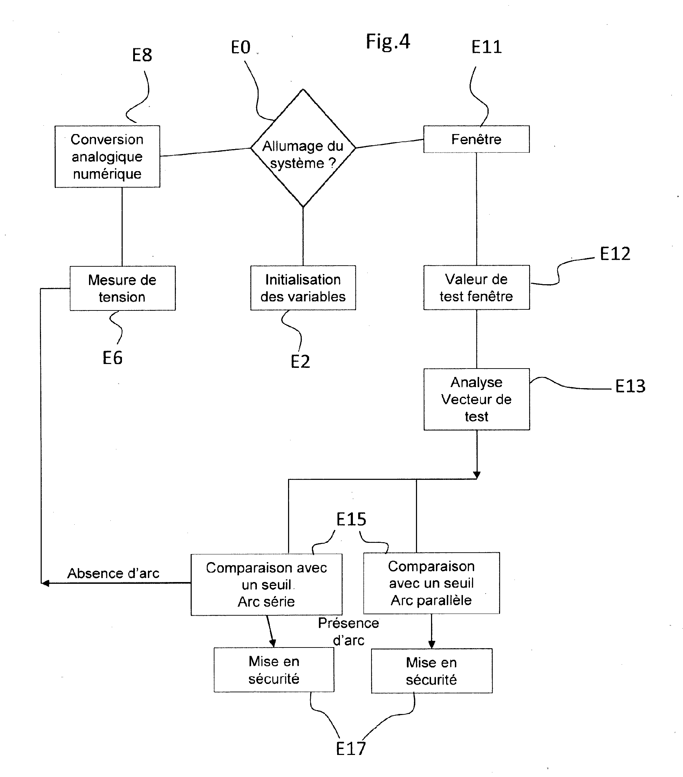

Le procédé de détection d'arc électrique selon l'invention va maintenant être détaillé, en référence avec la figure 4.

Il comprend une étape d'échantillonnage de valeurs de tension. Pour cela, différentes valeurs de tension sont mesurées au cours du temps, lors d'une étape de mesure E6, et numérisées, lors d'une étape de numérisation E8, par le convertisseur numérique de l'unité de traitement, selon une fréquence d'échantillonnage F_{ech} choisie. Ensuite, ces données de tension numérisées sont traitées pour en déduire une détection d'apparition ou non d'un arc électrique. La fréquence d'échantillonnage peut être comprise entre 50 kHz et 10 MHz.

Suite à ces étapes de saisie, le procédé vérifie d'abord s'il se trouve dans une phase d'initialisation, d'allumage du système, ou dans une phase de fonctionnement normal. Dans ce dernier cas, il poursuit par les étapes de traitement E11 à E13 décrites ci-après.

Le traitement comprend d'abord dans une première étape E11 du traitement la définition d'un nombre restreint de données de tension à considérer, qui peuvent correspondre aux n dernières mesures numérisées. Ces n valeurs obtenues forment un ensemble que nous appellerons une « fenêtre ».

Comme cette étape est répétée de préférence pour chaque nouvelle mesure, voire toutes les p nouvelles mesures obtenues, le principe de cette étape E11 revient à considérer une fenêtre glissante qui intègre les n dernières valeurs mesurées. Le paramètre n est prédéfini, voire réglable. Une faible valeur de n permet de considérer une fenêtre peu étendue et d'éliminer les phénomènes basse fréquence alors qu'une valeur élevée permet de considérer une fenêtre étendue et de discriminer les phénomènes haute fréquence, comme ceux découlant de parasites impulsionnels. De préférence, n est défini dans la phase d'initialisation du procédé puis reste constant durant toute la mise en oeuvre du procédé. Cette valeur de n dépend de la période d'échantillonnage du signal et de la période des phénomènes à observer. La montée de la tension dans le cas d'un arc électrique se fait en quelques microsecondes. Ainsi, à titre d'exemple, pour une fréquence d'échantillonnage de 2 microsecondes, une valeur de n = 32 est efficace pour détecter les phénomènes haute fréquence et n = 64 pour détecter les phénomènes basse fréquence. Plus généralement, on note que la valeur de n peut être choisie au sein d'une large plage, entre 3 à 1500, pour obtenir des résultats satisfaisants à partir d'une fréquence d'échantillonnage comprise entre 50kHz et 10MHz.

Une seconde étape E12 du traitement comprend l'estimation d'une valeur de test pour chaque fenêtre considérée précédemment. Cette valeur de test est représentative de l'état de l'installation photovoltaïque, et peut notamment prendre des valeurs particulières en cas d'arc électrique.

Selon un mode de réalisation, la valeur de test associée à une fenêtre est basée sur la différence entre les deux valeurs extrêmes de cette fenêtre, plus particulièrement la dernière valeur numérisée moins la première valeur numérisée de la fenêtre glissante. Cette approche présente l'avantage d'une grande simplicité de calcul.

En première variante, la différence mentionnée ci-dessus n'est pas directement retenue mais une valeur simplifiée et normalisée est choisie, déduite de cette différence, pour réduire les écarts possibles entre les valeurs de test et éviter la trop grande influence que pourraient avoir des valeurs de test importantes causées par exemple par des erreurs de mesure. Ainsi, dans cette variante, il est possible par exemple de choisir une valeur de test égale à 0 sous un certain seuil de la valeur absolue de la différence entre les valeurs extrêmes de la fenêtre et une valeur de test égale à 1 au-delà de ce seuil, ces valeurs de 0 et 1 étant choisis par convention à titre d'exemple.

Dans une seconde variante similaire à la précédente, le signe de la différence entre les valeurs extrêmes d'une fenêtre est considéré, car il est utilisé pour établir la distinction entre l'apparition d'un arc électrique de type série et un arc de type parallèle. Ainsi, si la différence mentionnée ci-dessus dépasse un premier seuil positif, alors une valeur de test de 1 est retenue, si cette différence est sous un second seuil négatif, une valeur de test de -1 est retenue, la valeur de test 0 étant retenue dans les autres cas.

Dans une troisième variante, d'autres valeurs sont utilisées, pour aller au-delà d'une simple approche binaire, en fonction d'autres seuils. Par exemple, les valeurs de test peuvent prendre les valeurs de -2, -1, 0, 1 ou 2 selon la comparaison de la différence des valeurs extrêmes de la fenêtre avec quatre seuils, deux de valeur positive et deux de valeur négative. Naturellement, tout autre étalement des valeurs de test est possible.

Dans une quatrième variante, la valeur de test peut être basée sur une différence entre la moyenne de quelques dernières valeurs et la moyenne de quelques anciennes valeurs de la fenêtre, ou la différence entre la seconde et l'avant-dernière valeur, ou toute autre différence permettant de distinguer une variation des valeurs au sein de la fenêtre. Ensuite, cette différence peut être traitée selon n'importe laquelle des approches ci-dessus.

Dans une cinquième variante, un autre calcul qu'une différence peut être mis en oeuvre, comme une division. Toutes les variantes précédentes peuvent ainsi être reprises à l'identique en remplaçant l'opération de soustraction par une division.

Les valeurs de test obtenues pour chaque fenêtre sont mémorisées dans une mémoire électronique associée à l'unité de traitement.

Une troisième étape E13 de traitement repose sur l'analyse des valeurs de test obtenues. Selon un mode de réalisation, un vecteur de test T est considéré, qui comprend les m dernières valeurs de test, m étant un paramètre prédéfini du procédé. Cette valeur de m dépend de la période d'échantillonnage du signal et de la période des phénomènes à observer. A titre d'exemple, pour une période d'échantillonnage de 2 microsecondes, une valeur intéressante est m = 32.

L'analyse de ces valeurs de test du vecteur de test peut reposer sur différents calculs, puis sur une comparaison du résultat retenu avec un ou deux seuils pour en déduire ou non la présence d'un arc électrique et éventuellement déduire le type, série ou parallèle, d'un arc électrique, dans une étape supplémentaire E15.

L'analyse des valeurs de test du vecteur de test peut reposer sur un calcul simple. Un mode de réalisation consiste à faire la somme de ces valeurs de test. En variante, un calcul différent de type statistique sur les valeurs du vecteur de test, comme la moyenne ou la médiane, peut être réalisé. Le calcul réalisé dans cette analyse du vecteur de test permet d'obtenir finalement une grandeur représentative du risque de présence d'un arc électrique : si cette grandeur dépasse un seuil, il est alors considéré qu'il y a présence d'un arc électrique.

En remarque, à partir des variantes mentionnées précédemment qui tiennent compte des signes, il est possible ici de définir deux seuils qui permettent de déduire la présence d'un arc série ou d'un arc électrique.

Les étapes de traitement E11 à E15 reposent sur des calculs simples, qui peuvent être réalisés rapidement et avec des moyens matériel et logiciel simples. Elles sont ainsi mises en oeuvre en temps réel ou quasi réel, selon la fréquence de mesure de tension choisie. Ces étapes de traitement sont répétées à chaque nouvelle mesure, une nouvelle fenêtre étant alors formée par le simple effacement de la dernière valeur et l'ajout de la nouvelle valeur (étape E11). On calcule ensuite la valeur de test de la nouvelle fenêtre (étape E12) et on considère un nouveau vecteur de test, dans lequel on supprime la dernière valeur et on ajoute cette nouvelle valeur de test (étape E13). Si aucun arc n'est détecté (étape E15) en fin de ce traitement, le procédé poursuit ses itérations avec une nouvelle mesure de tension (étape E6).

Plusieurs modes de réalisation du traitement décrit ci-dessus peuvent être déduits simplement par différentes combinaisons des variantes proposées à chaque étape du traitement.

Un autre mode de réalisation peut être formé en cumulant plusieurs traitements simultanés tels que décrits précédemment, ces différents traitements présentant des variantes permettant d'obtenir un résultat complémentaire, afin d'améliorer la fiabilité finale. Par exemple, il est possible d'implémenter à chaque itération le traitement précédent simultanément sur une courte fenêtre et sur une large fenêtre.

Le procédé de détection d'arc électrique précédemment décrit comprend une étape préliminaire d'initialisation, qui fixe la ou les valeur(s) de seuil mentionné(s) de manière automatique, dans une étape d'initialisation E2, en prenant en compte les premières valeurs de tension mesurées à l'allumage E0 du dispositif de sécurité.

En variante, toutes ces valeurs sont des paramètres préenregistrés, éventuellement modifiable par une interface homme machine. Dans ce cas, la phase d'initialisation se limite à l'atteinte d'un nombre suffisant de mesures pour pouvoir former un premier vecteur de test.

Dans tous les cas, le procédé comprend une étape de test E0 pour savoir si l'allumage du dispositif est terminé ou pas. Pour cela, il détecte si un nombre de mesures suffisant a été effectué pour pouvoir former un premier vecteur de test, c'est-à-dire avoir obtenu n+m mesures.

Enfin, lorsqu'un arc électrique est détecté, l'unité de traitement 8 associée à l'installation photovoltaïque envoie automatiquement une commande de mise en sécurité de l'installation photovoltaïque, dans une étape E17 du procédé, par l'intermédiaire du dispositif de communication 9 et du dispositif d'intervention 11. Cette mise en sécurité peut reposer sur des interrupteurs commandés à distance. Une commande de mise en sécurité peut représenter un ordre d'interruption du fonctionnement du système photovoltaïque, ce qui peut permettre de stopper l'arc électrique, en supprimant ainsi le risque que représenterait l'entretien de l'arc électrique, notamment le risque d'incendie.

D'autre part, le procédé peut aussi permettre de reconnaitre, à partir de l'échantillonnage de données analysé, si un arc électrique détecté est de type série ou parallèle, dans l'étape E15. Il peut alors engager des actions de mise en sécurité différente dans les deux cas à l'étape E17.

Le concept de l'invention ne se limite pas aux dispositifs photovoltaïques décrits ci-dessus mais peut être mis en oeuvre dans toute sorte d'installation photovoltaïque, avec de nombreux modules photovoltaïques.

Naturellement, le dispositif de sécurité 10 comprend avantageusement plusieurs capteurs de mesure de tension lorsque l'installation photovoltaïque est de grande dimension, par exemple un capteur pour chaque module photovoltaïque, ou pour un module sur deux ou trois, et au moins un capteur par chaine de modules photovoltaïques disposés en série, pour pouvoir détecter tout arc série. Pour obtenir une solution fiable, il est possible d'équiper le dispositif de deux capteurs de mesure de tension par chaine de modules photovoltaïques disposés en série, la redondance de ces capteurs permettant de pallier à une défaillance d'un capteur. Un tel capteur est avantageusement directement associé à un module photovoltaïque particulier, est par exemple directement disposé au sein du boîtier électronique d'un tel module. Le procédé de détection d'arc électrique est mis en oeuvre en parallèle pour chaque mesure de chaque capteur. Cette approche permet ainsi de garantir la sécurité de l'ensemble de l'installation, et de détecter au plus vite tout arc électrique. Elle permet aussi la localisation précise d'un arc électrique, et optionnellement une mise en sécurité localisée de l'installation photovoltaïque.

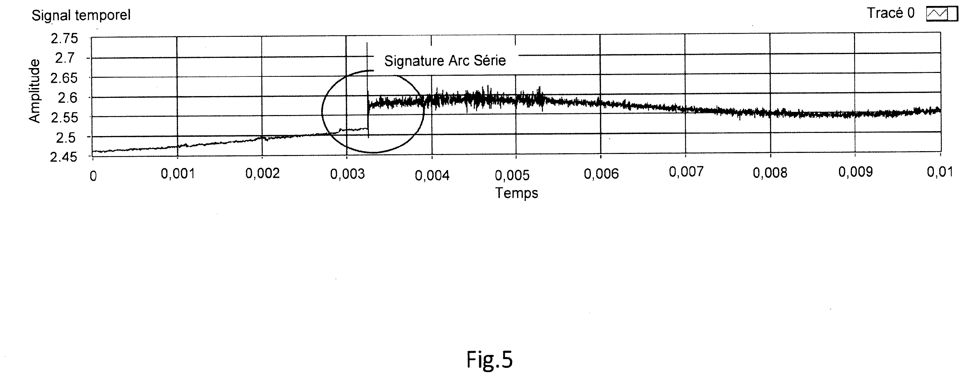

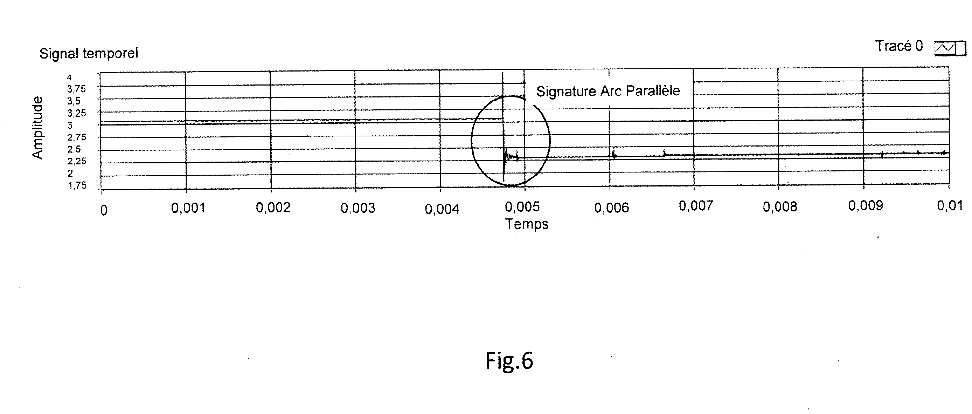

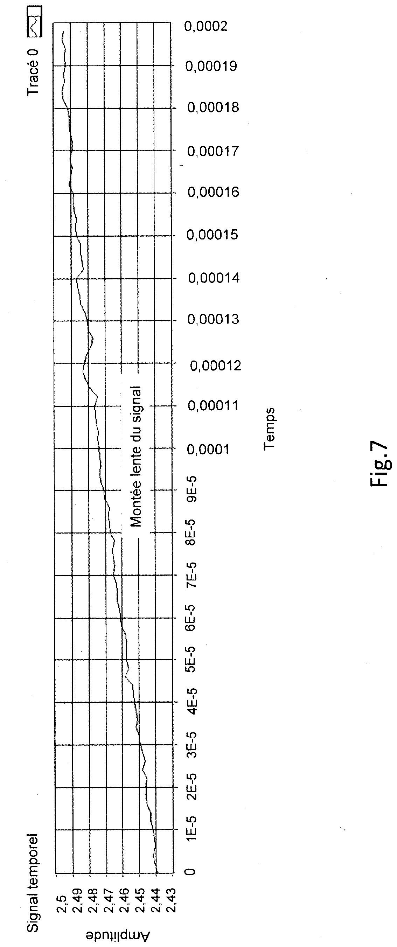

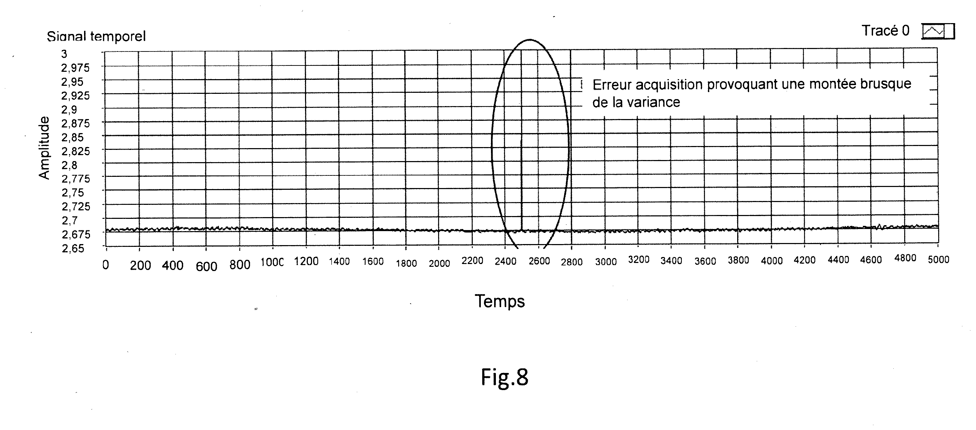

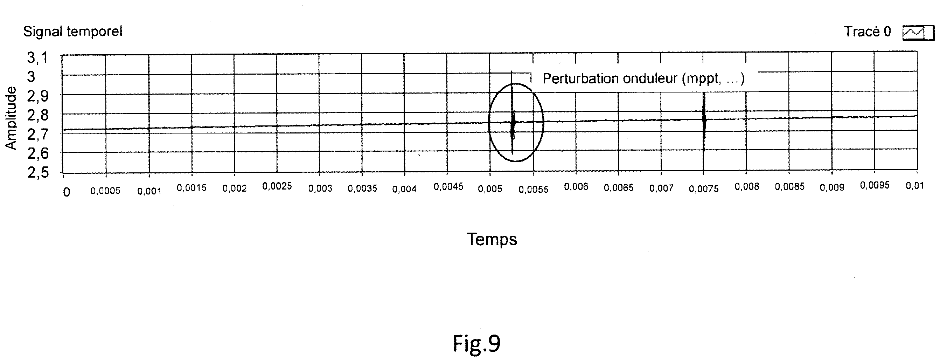

Le procédé décrit précédemment permet de manière remarquable d'obtenir une reconnaissance fiable de la présence d'un arc électrique dans une installation photovoltaïque avec des calculs très simples, ne nécessitant pas de moyens coûteux, et faciles à mettre en oeuvre en temps réel avec une fréquence d'échantillonnage contenue. Elle permet ainsi par exemple de distinguer l'apparition d'un arc série, dont la signature formée par l'évolution de la tension en fonction du temps est représentée en figure 5, ou l'apparition d'un arc parallèle, dont la signature formée par l'évolution de la tension en fonction du temps est représentée en figure 6. Elle permet de plus d'éviter les fausses détections lors de phénomènes voisins qui ne sont pas causés par un arc électrique, comme une simple montée de la tension telle que représentée en figure 7, une brusque montée ponctuelle de la tension du fait d'une erreur d'acquisition d'une mesure, telle que représentée en figure 8, ou une perturbation de la tension suite à une perturbation du fonctionnement de l'onduleur associé à l'installation photovoltaïque, telle que représentée en figure 9. Naturellement, la fiabilité et le taux de fausses détections du procédé sont réglables, en fonction de la définition des seuils mentionnés. Il sera avantageusement choisi des seuils permettant d'atteindre un taux de détection de 100%, sans grande marge supplémentaire pour minimiser le taux de fausse détection. Le procédé décrit précédemment se prête parfaitement à l'atteinte de cet objectif.

La solution retenue permet donc bien de répondre aux objets recherchés et présente les avantages suivants :
- comme le traitement repose sur la seule mesure de la tension, le procédé est simple ;
- ensuite, comme le procédé met en oeuvre une numérisation pour procéder à des calculs très simples, il ne nécessite pas une puissance de calcul importante ;
- ce procédé simplifié permet un calcul très rapide et en temps réel ;
- il atteint une grande fiabilité, tout arc électrique étant détecté, ce qui est très important pour la sécurité ;
- il atteint un taux de fausse détection très bas, ce qui minimise la mise en sécurité de l'installation de manière inutile ;
- enfin, le dispositif est simplifié au maximum et donc peu coûteux, puisqu'il ne nécessite pas de filtre. En variante, il reste compatible avec l'utilisation additionnelle et optionnelle d'un filtre ;
- cette solution est bien sûr compatible et complémentaire avec d'autres solutions de détection d'arc électrique, et peut donc être combinée avec ces autres solutions.

## Revendications

1. Procédé de détection d'un arc électrique dans une installation photovoltaïque, comprenant les étapes suivantes :
- Mesure (E6) de valeurs de tension en au moins un endroit du circuit électrique de l'installation photovoltaïque ;
- Numérisation (E8) des valeurs de tension mesurées pour former des données de tension ;
- Formation (E11) d'une fenêtre de n données de tension numérisées récentes;
- Calcul (E12) d'une valeur de test associée à ladite fenêtre des n données de tension, cette valeur reposant sur la seule mesure de la tension, **caractérisé en ce que** cette étape de calcul (E12) comprend l'un des calculs suivants :
- Calcul de la différence entre la donnée la plus récente et la donnée la plus ancienne de la fenêtre ou calcul de la différence entre la seconde donnée la plus récente et l'avant-dernière donnée la plus ancienne de la fenêtre, ou calcul de toute autre différence entre une donnée plus récente ou une moyenne de quelques données plus récentes de la fenêtre et une donnée plus ancienne ou la moyenne de quelques données plus anciennes de la fenêtre ; ou
- Calcul du rapport entre une donnée plus récente ou une moyenne de données plus récentes de la fenêtre et une donnée plus ancienne ou une moyenne de données plus anciennes de la fenêtre ; le procédé comprenant en plus les étapes suivantes:
- Analyse (E13) d'un vecteur de test comprenant m desdites valeurs de test associées à m fenêtres récentes générant une grandeur issue de cette analyse représentative d'un risque d'arc électrique, cette grandeur reposant sur la seule mesure de la tension ;
- Comparaison (E15) de cette grandeur issue avec au moins un seuil pour en déduire la présence ou non d'un arc électrique au sein de l'installation photovoltaïque.

2. Procédé de détection d'un arc électrique dans une installation photovoltaïque selon la revendication précédente, **caractérisé en ce que** l'étape de formation (E11) d'une fenêtre de n données de tension numérisées consiste à ajouter à la fenêtre précédemment formée une donnée nouvellement numérisée et à supprimer une donnée ancienne de la fenêtre.

3. Procédé de détection d'un arc électrique dans une installation photovoltaïque selon l'une des revendications précédentes, **caractérisé en ce que** l'étape de calcul (E12) d'une valeur de test associée à la fenêtre des n données comprend la comparaison du résultat du calcul de différence ou du rapport entre une donnée plus récente ou une moyenne de données plus récentes de la fenêtre et une donnée plus ancienne ou une moyenne de données plus anciennes de la fenêtre avec un ou plusieurs seuils et l'affectation d'une valeur de test prédéfinie, comme -2, - 1, 0, 1 ou 2, en fonction de cette comparaison.

4. Procédé de détection d'un arc électrique dans une installation photovoltaïque selon l'une des revendications précédentes, **caractérisé en ce que** l'étape (E13) d'analyse du vecteur de test comprend la somme des valeurs de test ou un calcul de type statistique sur les valeurs de test du vecteur de test, comme la moyenne ou la médiane, pour obtenir comme résultat une grandeur représentative du risque de présence d'arc électrique.

5. Procédé de détection d'un arc électrique dans une installation photovoltaïque selon la revendication précédente, **caractérisé en ce qu'**il comprend une étape de comparaison (E15) de la grandeur avec un premier seuil pour en déduire la présence ou non d'un arc électrique de type série et la comparaison de cette grandeur avec un second seuil de signe opposé au premier seuil pour en déduire la présence ou non d'un arc électrique de type parallèle.

6. Procédé de détection d'un arc électrique dans une installation photovoltaïque selon l'une des revendications précédentes, **caractérisé en ce qu'**il comprend la répétition des étapes suivantes à chaque nouvelle mesure de tension :
- formation (E11) d'une nouvelle fenêtre par effacement de la donnée de tension la plus ancienne de la fenêtre précédente et l'ajout de la donnée de tension la plus récente ;
- calcul de la valeur de test de la nouvelle fenêtre (étape E12) ;
- élaboration (E13) d'un nouveau vecteur de test, dans lequel on supprime la valeur de test associée à la fenêtre la plus ancienne et on ajoute la nouvelle valeur de test puis
- détection (E15) ou non de la présence d'un arc électrique à partir de ce nouveau vecteur de test,
- si aucun arc électrique n'est détecté, itération des étapes précédentes à partir d'une nouvelle mesure de tension (E6).

7. Procédé de détection d'un arc électrique dans une installation photovoltaïque selon la revendication précédente, **caractérisé en ce qu'**il comprend une étape de mémorisation des données de tension de la fenêtre et des valeurs de test du vecteur de test à chaque itération.

8. Procédé de détection d'un arc électrique dans une installation photovoltaïque selon la revendication 6 ou 7, **caractérisé en ce qu'**il comprend la réalisation des étapes de détection ou non de la présence d'un arc électrique en temps réel.

9. Procédé de détection d'un arc électrique dans une installation photovoltaïque selon l'une des revendications précédentes, **caractérisé en ce qu'**il combine les étapes de détection d'un arc électrique dans l'installation photovoltaïque à partir d'une même mesure de tension pour deux fenêtres comprenant un nombre différent de données.

10. Procédé de détection d'un arc électrique dans une installation photovoltaïque selon l'une des revendications précédentes, **caractérisé en ce qu'**il comprend une mesure de tension à une fréquence d'échantillonnage comprise entre 50 kHz et 10M Hz.

11. Procédé de détection d'un arc électrique dans une installation photovoltaïque selon l'une des revendications précédentes, **caractérisé en ce que** s'il est estimé qu'il existe un arc électrique au sein de l'installation photovoltaïque, le procédé comprend une étape (E17) consistant à intervenir automatiquement sur le circuit électrique de l'installation photovoltaïque pour mettre l'installation photovoltaïque en sécurité.

12. Dispositif de sécurité pour une installation photovoltaïque, comprenant une unité de traitement (8) et un ou plusieurs capteur(s) de mesure de tension (6), relié(s) par une liaison de communication (7) à ladite unité de traitement (8), l'unité de traitement comprenant un convertisseur analogique numérique pour numériser les mesures reçues par le ou les capteur(s) de mesure de tension, **caractérisé en ce que** l'unité de traitement (8) est configurée pour mettre en oeuvre le procédé de détection d'un arc électrique dans l'installation photovoltaïque selon l'une des revendications précédentes.

13. Dispositif de sécurité pour une installation photovoltaïque selon la revendication précédente, **caractérisé en ce que** l'unité de traitement (8) est reliée par un moyen de communication (9) à un dispositif d'intervention (11) dont la fonction est de mettre l'installation en sécurité en cas d'arc électrique.

14. Installation photovoltaïque, **caractérisée en ce qu'**elle comprend au moins un dispositif de sécurité selon la revendication 12 ou 13.

## Patentansprüche

1. Verfahren zur Erkennung eines Lichtbogens in einer Photovoltaikanlage, das die folgenden Schritte enthält:
- Messung (E6) von Spannungsdaten an mindestens einer Stelle des Stromkreises der Photovoltaikanlage;
- Digitalisierung (E8) der gemessenen Spannungswerte, um Spannungsdaten zu bilden;
- Bildung (E11) eines Fensters von n jüngsten digitalisierten Spannungsdaten;
- Berechnung (E12) eines dem Fenster der n Spannungsdaten zugeordneten Testwerts, wobei dieser Wert nur auf der Messung der Spannung beruht,
**dadurch gekennzeichnet, dass** dieser Berechnungsschritt (E12) eine der folgenden Berechnungen enthält:
- Berechnung der Differenz zwischen dem jüngsten Datenwert und dem ältesten Datenwert des Fensters oder Berechnung der Differenz zwischen dem zweiten jüngsten Datenwert und dem vorletzten ältesten Datenwert des Fensters, oder Berechnung jeder anderen Differenz zwischen einem jüngeren Datenwert oder einem Mittelwert einiger jüngerer Daten des Fensters und einem älteren Datenwert oder dem Mittelwert einiger älterer Daten des Fensters; oder
- Berechnung des Verhältnisses zwischen einem jüngeren Datenwert oder einem Mittelwert jüngerer Daten des Fensters und einem älteren Datenwert oder einem Mittelwert älterer Daten des Fensters;
wobei das Verfahren außerdem die folgenden Schritte enthält:
- Analyse (E13) eines Testvektors, der m der m Fenstern zugeordneten jüngeren Testwerte enthält, was eine aus dieser Analyse entstandene Größe erzeugt, die für ein Lichtbogenrisiko repräsentativ ist, wobei diese Größe nur auf der Messung der Spannung beruht;
- Vergleich (E15) dieser entstandenen Größe mit mindestens einer Schwelle, um daraus die Präsenz oder nicht eines Lichtbogens in der Photovoltaikanlage abzuleiten.

2. Verfahren zur Erkennung eines Lichtbogens in einer Photovoltaikanlage nach dem vorhergehenden Anspruch, **dadurch gekennzeichnet, dass** der Schritt der Bildung (E11) eines Fensters von n digitalisierten Spannungsdaten darin besteht, zum vorher gebildeten Fenster einen neu digitalisierten Datenwert hinzuzufügen und einen alten Datenwert des Fensters zu entfernen.

3. Verfahren zur Erkennung eines Lichtbogens in einer Photovoltaikanlage nach einem der vorhergehenden Ansprüche, **dadurch gekennzeichnet, dass** der Schritt der Berechnung (E12) eines dem Fenster der n Daten zugeordneten Testwerts den Vergleich des Ergebnisses der Differenzrechnung oder des Verhältnisses zwischen einem jüngeren Datenwert oder einem Mittelwert jüngerer Daten des Fensters und einem älteren Datenwert oder einem Mittelwert älterer Daten des Fensters mit einer oder mehreren Schwellen und die Zuweisung eines vordefinierten Testwerts, wie -2, -1, 0, 1 oder 2, abhängig von diesem Vergleich enthält.

4. Verfahren zur Erkennung eines Lichtbogens in einer Photovoltaikanlage nach einem der vorhergehenden Ansprüche, **dadurch gekennzeichnet, dass** der Schritt (E13) der Analyse des Testvektors die Summe der Testwerte oder eine Berechnung statistischer Art über die Testwerte des Testvektors, wie der Mittelwert oder der Median, enthält, um als Ergebnis eine für das Risiko einer Lichtbogenpräsenz repräsentative Größe zu erhalten.

5. Verfahren zur Erkennung eines Lichtbogens in einer Photovoltaikanlage nach dem vorhergehenden Anspruch, **dadurch gekennzeichnet, dass** es einen Schritt des Vergleichs (E15) der Größe mit einer ersten Schwelle, um daraus die Präsenz oder nicht eines seriellen Lichtbogens abzuleiten, und den Vergleich dieser Größe mit einer zweiten Schwelle entgegengesetzten Vorzeichens zur ersten Schwelle enthält, um daraus die Präsenz oder nicht eines parallelen Lichtbogens abzuleiten.

6. Verfahren zur Erkennung eines Lichtbogens in einer Photovoltaikanlage nach einem der vorhergehenden Ansprüche, **dadurch gekennzeichnet, dass** es die Iteration der folgenden Schritte bei jeder neuen Spannungsmessung enthält:
- Bildung (E11) eines neuen Fensters durch Löschen des ältesten Spannungsdatenwerts des vorhergehenden Fensters und Hinzufügen des jüngsten Spannungsdatenwerts;
- Berechnung des Testwerts des neuen Fensters (Schritt E12);
- Erarbeitung (E13) eines neuen Testvektors, wobei der dem Fenster zugeordnete älteste Testwert entfernt und der neue Testwert hinzugefügt wird, dann
- Erkennung (E15) oder nicht der Präsenz eines Lichtbogens ausgehend von diesem neuen Testvektor,
- wenn kein Lichtbogen erkannt wird, Iteration der vorhergehenden Schritte ausgehend von einer neuen Spannungsmessung (E6).

7. Verfahren zur Erkennung eines Lichtbogens in einer Photovoltaikanlage nach dem vorhergehenden Anspruch, **dadurch gekennzeichnet, dass** es einen Schritt des Speicherns der Spannungsdaten des Fensters und der Testwerte des Testvektors bei jeder Iteration enthält.

8. Verfahren zur Erkennung eines Lichtbogens in einer Photovoltaikanlage nach Anspruch 6 oder 7, **dadurch gekennzeichnet, dass** es die Durchführung der Schritte der Erkennung oder nicht der Präsenz eines Lichtbogens in Echtzeit enthält.

9. Verfahren zur Erkennung eines Lichtbogens in einer Photovoltaikanlage nach einem der vorhergehenden Ansprüche, **dadurch gekennzeichnet, dass** es die Schritte der Erkennung eines Lichtbogens in der Photovoltaikanlage ausgehend von einer gleichen Spannungsmessung für zwei Fenster enthält, die eine unterschiedliche Anzahl von Daten enthalten.

10. Verfahren zur Erkennung eines Lichtbogens in einer Photovoltaikanlage nach einem der vorhergehenden Ansprüche, **dadurch gekennzeichnet, dass** es eine Spannungsmessung bei einer Probennahmefrequenz zwischen 50 kHz und 10 MHz enthält.

11. Verfahren zur Erkennung eines Lichtbogens in einer Photovoltaikanlage nach einem der vorhergehenden Ansprüche, **dadurch gekennzeichnet, dass**, wenn angenommen wird, dass ein Lichtbogen in der Photovoltaikanlage existiert, das Verfahren einen Schritt (E17) enthält, der darin besteht, automatisch in den Stromkreis der Photovoltaikanlage einzugreifen, um die Photovoltaikanlage abzusichern.

12. Sicherheitsvorrichtung für eine Photovoltaikanlage, die eine Verarbeitungseinheit (8) und einen oder mehrere Spannungsmesssensor(en) (6) enthält, der(die) durch eine Kommunikationsverbindung (7) mit der Verarbeitungseinheit (8) verbunden ist(sind), wobei die Verarbeitungseinheit einen Analog-Digital-Wandler enthält, um die von dem oder den Spannungsmesssensor(en) empfangenen Messwerte zu digitalisieren, **dadurch gekennzeichnet, dass** die Verarbeitungseinheit (8) konfiguriert ist, das Verfahren zur Erkennung eines Lichtbogens in der Photovoltaikanlage nach einem der vorhergehenden Ansprüche durchzuführen.

13. Sicherheitsvorrichtung für eine Photovoltaikanlage nach dem vorhergehenden Anspruch, **dadurch gekennzeichnet, dass** die Verarbeitungseinheit (8) durch eine Kommunikationseinrichtung (9) mit einer Eingreifvorrichtung (11) verbunden ist, deren Aufgabe es ist, die Anlage im Fall eines Lichtbogens abzusichern.

14. Photovoltaikanlage, **dadurch gekennzeichnet, dass** sie mindestens eine Sicherheitsvorrichtung nach Anspruch 12 oder 13 enthält.

## Claims

1. Method for detecting an electric arc in a photovoltaic installation, **characterized in that** it comprises the following steps:
- Measurement (E6) of voltage values at at least one site of the electrical circuit of the photovoltaic installation;
- Digitization (E8) of the measured voltage values so as to form voltage data;
- Formation (E11) of a window of n recent digitized voltage data;
- Computation (E12) of a test value associated with the said window of the n voltage data, this value resting upon the sole measurement of the voltage, **characterized in that** the step (E12) of computation comprises one of the following computations:
- computation of the difference between the most recent datum and the oldest datum of the window or computation of the difference between the second most recent datum and the penultimate oldest datum of the window, or computation of any other difference between a more recent datum or a mean of a few more recent data of the window and an older datum or the mean of a few older data of the window; or
- computation of the ratio between a more recent datum or a mean of more recent data of the window and an older datum or a mean of older data of the window ; the method comprising also the following steps :
- Analysis (E13) of a test vector comprising m of said test values associated with m recent windows generating a quantity arising from this analysis representative of a risk of electric arc, this quantity resting upon the sole measurement of the voltage;
- Comparison (E15) of this quantity arising with at least one threshold so as to deduce therefrom the presence or otherwise of an electric arc within the photovoltaic installation.

2. Method for detecting an electric arc in a photovoltaic installation according to the preceding claim, **characterized in that** the step (E11) of formation of a window of n digitized voltage data consists in adding a newly digitized datum to the previously formed window and in eliminating an old datum from the window.

3. Method for detecting an electric arc in a photovoltaic installation according to one of the preceding claims, **characterized in that** the step (E12) of computation of a test value associated with the window of the n data comprises the comparison of the result of the difference computation or of the ratio between a more recent datum or a mean of more recent data of the window and an older datum or a mean of older data of the window with one or more thresholds and the assignment of a predefined test value, such as -2, -1, 0, 1 or 2, as a function of this comparison.

4. Method for detecting an electric arc in a photovoltaic installation according to one of the preceding claims, **characterized in that** the step (E13) of analysis of the test vector comprises the sum of the test values or a computation of statistical type on the test values of the test vector, such as the mean or the median, so as to obtain as result a quantity representative of the risk of the presence of electric arc.

5. Method for detecting an electric arc in a photovoltaic installation according to the preceding claim, **characterized in that** it comprises a step (E15) of comparison of the quantity with a first threshold so as to deduce therefrom the presence or otherwise of an electric arc of series type and the comparison of this quantity with a second threshold of opposite sign to the first threshold so as to deduce therefrom the presence or otherwise of an electric arc of parallel type.

6. Method for detecting an electric arc in a photovoltaic installation according to one of the preceding claims, **characterized in that** it comprises the repetition of the following steps at each new voltage measurement:
- formation (E11) of a new window by deletion of the oldest voltage datum of the previous window and the addition of the most recent voltage datum;
- computation of the test value of the new window (step E12);
- devising (E13) of a new test vector, in which the test value associated with the oldest window is eliminated and the new test value is added and then
- detection (E15) or otherwise of the presence of an electric arc on the basis of this new test vector,
- if no electric arc is detected, iteration of the previous steps on the basis of a new voltage measurement (E6).

7. Method for detecting an electric arc in a photovoltaic installation according to the preceding claim, **characterized in that** it comprises a step of storing the voltage data of the window and the test values of the test vector at each iteration.

8. Method for detecting an electric arc in a photovoltaic installation according to Claim 6 or 7, **characterized in that** it comprises the realization of the steps of detection or otherwise of the presence of an electric arc in real time.

9. Method for detecting an electric arc in a photovoltaic installation according to one of the preceding claims, **characterized in that** it combines the steps of detecting an electric arc in the photovoltaic installation on the basis of one and the same voltage measurement for two windows comprising a different number of data.

10. Method for detecting an electric arc in a photovoltaic installation according to one of the preceding claims, **characterized in that** it comprises a voltage measurement at a sampling frequency lying between 50 kHz and 10 MHz.

11. Method for detecting an electric arc in a photovoltaic installation according to one of the preceding claims, **characterized in that** if it is estimated that an electric arc exists within the photovoltaic installation, the method comprises a step (E17) consisting in intervening automatically on the electrical circuit of the photovoltaic installation so as to make the photovoltaic installation safe.

12. Safety device for a photovoltaic installation, comprising a processing unit (8) and one or more voltage measurement sensor(s) (6), linked by a communication link (7) to said processing unit (8), the processing unit (8) comprising an analogue-digital converter for digitizing the measurements received by the voltage measurement sensor(s), **characterized in that** the processing unit (8) implements the method for detecting an electric arc in the photovoltaic installation according to one of the preceding claims.

13. Safety device for a photovoltaic installation according to the preceding claim, **characterized in that** the processing unit (8) is linked by a communication means (9) to an intervention device (11) whose function is to make the installation safe in case of electrical arcing.

14. Photovoltaic installation, **characterized in that** it comprises at least one safety device according to Claim 12 or 13.
